# EUROPÄISCHE PATENTSCHRIFT

(11) **EP 1 007 766 B1**
(45) Veröffentlichungstag und Bekanntmachung des Hinweises auf die Patenterteilung: **02.05.2002**
(21) Anmeldenummer: 98951219.9
(22) Anmeldetag: 19.08.1998
(51) Int. Cl.: C25D 17/00

(54) **VORRICHTUNG UND VERFAHREN ZUM VERGLEICHMÄSSIGEN DER DICKE VON METALLSCHICHTEN AN ELEKTRISCHEN KONTAKTIERSTELLEN AUF BEHANDLUNGSGUT**
DEVICE AND METHOD FOR EVENING OUT THE THICKNESS OF METAL LAYERS ON ELECTRICAL CONTACT POINTS ON ITEMS THAT ARE TO BE TREATED
DISPOSITIF ET PROCEDE POUR EGALISER L'EPAISSEUR DE COUCHES METALLIQUES AU NIVEAU DES POINTS DE MISE EN CONTACT ELECTRIQUES SUR UN PRODUIT A TRAITER

(30) Priorität: 21.08.1997 DE 19736352
(43) Veröffentlichungstag der Anmeldung: 14.06.2000
(73) Patentinhaber: ATOTECH Deutschland GmbH, 10553 Berlin (DE)
(72) Erfinder: KOPP, Lorenz, D-90518 Altdorf (DE); LANGHEINRICH, Peter, D-90537 Feucht (DE); SCHNEIDER, Reinhard, D-90556 Cadolzburg (DE)
(74) Vertreter: Effert, Bressel und Kollegen
(86) Internationale Anmeldenummer: DE9802503
(87) Internationale Veröffentlichungsnummer: WO9910568

(56) Entgegenhaltungen:
- DE-A- 3 027 751
- DE-C- 3 726 571
- US-A- 4 755 271
- US-A- 4 776 939
- US-A- 4 879 007
- US-A- 5 391 276
- US-A- 5 401 370

## Beschreibung

Die Erfindung betrifft eine Vorrichtung und ein Verfahren zum Vergieichmäßigen der Dicke von Metallschichten an elektrischen Kontaktierstellen auf flachem Behandlungsgut, wie Leiterfolien und Leiterplatten, bei der elektrolytischen Behandlung, insbesondere elektrolytischen Metallisierung, des in einer horizontalen Transportebene in einer Durchlaufgalvanisieranlage geführten Behandlungsgutes. Insbesondere findet die Vorrichtung Anwendung in Anlagen, in denen das Behandlungsgut in horizontaler Lage geführt wird.

In Galvanisieranlagen zur Metallabscheidung wird flaches Behandlungsgut üblicherweise einseitig oder beidseitig am Rand von Klemmen oder Klammern gegriffen. Die Klemmen bzw. Klammern dienen zum Transport des Behandlungsgutes durch die Anlage und zugleich zur elektrischen Kontaktierung, d.h. zur Zuführung des Galvanisierstromes zum Gut. Bei dem Behandlungsgut handelt es sich zum Beispiel um Leiterplatten, insbesondere sogenannte Multilayer (Mehrtagenschaltungen), mit Plattendicken bis zu 8 mm. Es kommt vor, daß in einer Durchlaufgalvanisieranlage sowohl derartige dicke Platte als auch Folien mit einer Dicke von nur 0,1 mm oder weniger produziert werden.

Eine weitere Anforderung an eine Galvanisieranlage besteht in der geforderten Gleichmäßigkeit und Genauigkeit der Verteilung der Metallschichtdicke. Die elektrolytisch abgeschiedenen Metallschichten müssen aus technischen und wirtschaftlichen Gründen bis in die Randbereiche des Behandlungsgutes hinein sehr gleichmäßig dick sein. Die Randbereiche, in denen sich deutliche Abweichungen von der vorgegebenen Normschichtdicke einstellen, sollen möglichst schmal sein. Bei der Feinleitertechnik (Leiterbahnbreiten und -abstände von etwa 120 µm und weniger) wird beispielsweise eine relative Schichtdickentoleranz im nutzbaren Bereich des Behandlungsgutes (außerhalb des nicht nutzbaren Randbereiches) gefordert, die unter 10 Prozent liegt. Auch in der Nähe der Stellen auf dem Behandlungsgut, an denen die Klemmen bzw. Klammern während der Galvanisierung ansetzen, kann die geforderte gleichmäßige Schichtdickenverteilung nicht erreicht werden. Daher zählen die Bereiche in der Nähe dieser Kontaktstellen zu den Randbereichen hinzu.

In DE 36 24 481 C2 wird eine Klammer beschrieben, die in einer horizontalen Durchlaufgalvanisieranlage verwendet wird. An einem umlaufenden Transportband sind viele derartige Klammern voneinander beabstandet befestigt. Am Einlauf der Galvanisieranlage wird das Behandlungsgut am seitlichen Rand von den Klammern ergriffen. Hierzu werden zwei Bügel gegeneinander verschwenkt und der Rand des Behandlungsgutes von der Klammer mit Hilfe einer Druckfeder in der Klammer festgehalten. In einer anderen Ausführungsform wird zum Öffnen der Klammer vorgeschlagen, die Bügel senkrecht gegeneinander zu verschieben. Die Kontaktkraft wird in diesem Falle von einer Zugfeder aufgebracht. Am Auslauf der Galvanisieranlage werden die Klammern mittels einer schrägen Anlauffläche wieder geöffnet. Damit werden die Leiterplatten wieder freigegeben und in der Regel von Transportwalzen weitertransportiert.

Beim Galvanisieren von Behandlungsgut werden zugleich auch die metallischen Bügel der Klammern metallisiert. Diese wirken somit als Raubkathoden in Bezug auf die in der Nähe der Klammern gelegene Oberfläche des Behandlungsgutes. Wegen der sich in diesem Bereich einstellenden geringeren Schichtdicke kann ein entsprechend breiter Randstreifen nicht genutzt werden. Erfahrungsgemäß beträgt diese nicht nutzbare Breite etwa 60 mm. Um die Ausbildung von Schichtdickenschwankungen zu vermeiden, wird in der genannten Druckschrift empfohlen, die Bügel mit einer Kunststoffumhüllung zu versehen. Nur die Enden, die den Kontakt zum Behandlungsgut herstellen, sollen danach metallisch blank bleiben. In der Druckschrift ist ferner angegeben, daß diese Stellen beim Rücklauf der Klammern in der Anlage in einer Entmetallisierungskammer elektrolytisch wieder entmetallisiert werden.

Die Kunststoffumhüllung ermöglicht den Betrieb der Klammern innerhalb des Elektrolytbades. Zusätzliche Dichtwände zum Fernhalten des Elektrolyten von den Klammern sind daher nicht nötig. Diese Betriebsart soll nachfolgend als Naßkontaktierung bezeichnet werden. Die Kunststcffumhüllung der Klammern besteht zum Beispiel aus ECTFE (Poly(ethylen-trichlorfluorethylen)). Die Fertigung eines Kunststoffüberzuges mit diesem chemisch beständigen Kunststoff ist sehr aufwendig und damit teuer.

Mechanische Beschädigungen des Kunststoffüberzuges, verursacht durch scharfkantige Werkzeuge oder Leiterplatten, kann jedoch auch bei Verwendung dieses oder eines anderen geeigneten Kunststoffes nicht vermieden werden. Die Standzeit der Klammern beträgt daher durchschnittlich nur zwölf Monate.

Die Klammern sind beim Galvanisieren kathodisch gepolt. In der Praxis zeigt sich, daß die Kunststoffumhüllung vieler Klammern nach längerer Benutzungsdauer metallisiert wird. Die unerwünschte Metallisierung findet selbst dann statt, wenn die Klammern im Rücklauf regelmäßig elektrolytisch entmetallisiert werden. Die Ursachen hierfür sind allerdings nicht bekannt. Vermutlich spielt dabei die Alterung der Kunststoffumhüllung in Verbindung mit den organischen und/oder anorganischen Elektrolytzusätzen eine Rolle: Die fest haftende metallische Schicht auf der Kunststoffumhüllung beginnt im Elektrolyten von metallisch blanken Stellen der Klammern aus zu wachsen, beispielsweise die blanken Kontaktstellen an den Enden der Bügel. Insbesondere sind dies aber auch Beschädigungen der Kunststoffumhüllungen der Klammern, die durch Reinigungsarbeiten während des rauhen Betriebes, zum Beispiel durch nicht richtig positionierte und sehr scharfkantige Leiterplatten oder durch unsachgerechte Behandlung der Umhüllungen, verursacht werden.

Folgende Vorgänge laufen dabei ab: Durch die zum Teil sehr kleinen offenen Schadstellen, wie zum Beispiel Risse in den Kunststoffumhüllungen, beginnt eine Galvanisierung, die eine dünne elektrisch leitfähige Verbindung zwischen dem Metallbügel der Klammer und der auf der Außenseite der Kunststoffumhüllung langsam aufwachsenden metallischen Schicht herstellt. Im Rücklauf der Klammer in der Durchlaufgalvanisieranlage soll die Galvanisierschicht elektrolytisch abgetragen werden. Die elektrisch leitfähige Verbindung in einer Schadstelle wird zuerst bevorzugt und damit in kurzer Zeit abgetragen. Damit geht die elektrische Verbindung der aufgewachsenen Metallschicht auf der Kunststoffumhüllung zum Metallbügel verloren, noch bevor diese elektrolytisch vollständig entfernt werden konnte. Befindet sich die Klammer wieder im Metallisierungsbereich der Galvanisieranlage, wird die verbliebene Metallisierung durch die Schadstelle wieder elektrisch leitfähig, indem innerhalb der Schadstelle neues Metall über die elektrische Verbindung mit dem Metallbügel elektrolytisch abgeschieden wird. Die Metallisierung wächst daher weiter. Dieser sich wiederholende langsame Vorgang führt in einer im Dauerbetrieb befindlichen Anlage nach Wochen oder Monaten zur Unbrauchbarkeit der Klammern, da die unerwünschte Metallisierung auf der Kunststoffumhüllung gegenüber der Metallisierung auf dem Behandlungsgut als Raubkathode wirkt. Die Kunststoffumhüllung muß daher erneuert werden. Dies ist mit hohen Kosten verbunden. Zusätzlich entsteht ein Produktionsausfall.

In DE 32 36 545 C3 ist eine Vorrichtung zum Elektroplattieren einzelner, plattenförmiger Werkstücke beschrieben, die nacheinander in einer horizontal gerichteten Bewegung mittels drehbarer Fördereinrichtungen durch ein eingangsund ausgangsseitig mit Dichtungen versehenes elektrolytisches Bad geführt werden, wobei als Fördereinrichtung im Bad und insbesondere auch zur elektrischen Kontaktierung der Werkstücke an einer Seite des Förderweges eine Mehrzahl von kathodisch geschalteten, paarweise gegenüberliegenden und gegeneinander drückbaren Kontakträdern vorgesehen ist. Ferner sind die Kontakträder zu ihrer vollständigen Abschirmung gegenüber dem Bad mit Abdekkungen versehen, die für den Durchgang der Werkstücke passend geschlitzte Öffnungen aufweisen, wobei längs der geschlitzten Öffnungen der Abdeckungen Wischeinrichtungen vorgesehen und vor den Abdeckungen getragen sind, die auf den Werkstücken schleifend aufliegen, um den Kontakt der Kontakträder mit der elektrolytischen Flüssigkeit einzuschränken.

Es hat sich herausgestellt, daß diese Kontakträder für die elektrolytische Metallabscheidung auf Behandlungsgut nicht geeignet sind, da sich nicht vermeiden läßt, daß Metall auf den Stirnseiten der Räder abgeschieden wird. Durch die Metallabscheidung wird deren Durchmesser allmählich größer, und insbesondere werden die Stirnseiten der Räder rauh und beschädigen daher die Behandlungsgutoberflächen. Zur Entfernung von Metall von den Rädern müssen diese sporadisch ausgebaut und von Metall befreit werden. Hierzu muß die gesamte Anlage stillgelegt werden. Dies führt nicht nur zu einer geringeren Produktivität der Anlage sondern auch zu weiteren Folgeschäden, beispielsweise Ausschußproduktion in der anschließenden Startphase beim Wiederanfahren der Anlage, da die Metallisierungsbäder im allgemeinen zunächst eingefahren werden müssen bis sich die Abscheidungsbedingungen im Bad wieder stabilisiert haben.

In EP 0 254 962 A1 werden Kontaktklemmen beschrieben, die für eine Trokkenkontaktierung vorgesehen sind. Die Kontaktklemmen werden hierzu mittels einer am Behandlungsgut anliegenden Dichtung vor dem Zutritt der Elektrolytlösung abgeschirmt. Trotzdem ist in der Druckschrift erwähnt, daß die übrigen, nicht der Kontaktierung dienenden Bereiche der Kontaktklemmen zum Schutz vor einer unerwünschten Metallabscheidung mit Kunststoff überzogen sind. Unerwünschte Abscheidungen auf den Kontaktklemmen werden durch chemische und/oder mechanische Reinigung im Rücklauf der Klemmen entfernt. Die Abdichtung der Kathodenklemmen durch eine unter Federdruck auf dem Behandlungsgut anliegende Dichtung führt zu Nachteilen, weil Leiterplatten stets scharfkantig sind. Löcher im Randbereich der Leiterplatten, die zum Beispiel zur Positionierung oder Codierung der Platten erforderlich sind, weisen ebenfalls scharfe Kanten auf. Die Dichtungen verschleißen daher schnell. Der dabei entstehende Abrieb von den Dichtungen gelangt zwangsläufig in den Elektrolyten und wird in der Folge in die Galvanisierschicht auf der Leiterplattenoberfläche eingebunden. Derartiges Behandlungsgut ist Ausschuß. Ferner besteht die Gefahr, daß Leiterfolien von der fest anliegenden Dichtung verzogen und/oder geknittert werden. Bei dickeren Platten ist eine vollständige Abdichtung dagegen nicht möglich, weil im Spalt zwischen zwei aufeinanderfolgenden Leiterplatten Elektrolyt an die Kontaktklemmen und an weitere Konstruktionselemente der Anlage gelangt. Ein unkontrolliertes Metallisieren von kathodisch gepolten Teilen sowie eine Korrosion von Transportelementen durch den Elektrolyten ist folglich nicht zu vermeiden.

Der Erfindung liegt von daher das Problem zugrunde, die Nachteile der bekannten Vorrichtungen und Verfahren zu vermeiden und insbesondere eine Vorrichtung anzugeben, mit der kostengünstig produziert werden kann und die einen weitgehend wartungsfreien Dauerbetrieb ermöglicht. Vor allem soll eine gleichmäßige Schichtdickenverteilung auf dem Behandlungsgut und in dessen Löchern sowohl bei dicken Leiterplatten als auch bei dünnen Leiterfolien erhalten werden können, die auch im Randbereich des Behandlungsgutes ohne Umrüstung der Anlage erreichbar ist.

Das Problem wird gelöst durch die Vorrichtung nach Anspruch 1 und das Verfahren nach Anspruch 11.

Die erfindungsgemäße Vorrichtung und das Verfahren dienen zum Vergleichmäßigen der Dicke von Metallschichten an elektrischen Kontaktierstellen bei der elektrolytischen Behandlung des Behandlungsgutes. Die Vorrichtung enthält der Transportebene gegenüberliegende Gegenelektroden und an einem endlos umlaufenden Transportmittel befestigte Klammern zum Kontaktieren des Behandlungsgutes. Die Klammern weisen jeweils ein Klammerunterteil und ein Klammeroberteil auf, die elektrisch leitfähig sind, an der Oberfläche aus Metall bestehen, relativ zueinander beweglich sind und jeweils mindestens eine Kontaktstelle für das Behandlungsgut aufweisen. Ferner ist mindestens eine Stromquelle zum Erzeugen eines Stromflusses zwischen den Gegenelektroden und den Klammern vorgesehen. Zwischen den Gegenelektroden und den Klammern sind obere und untere Abschirmungen für das elektrische Feld angeordnet, die so nahe an die Transportebene heranreichen, daß das in der Transportebene geführte Behandlungsgut und die Klammerteile von den Abschirmungen gerade noch nicht berührt werden können.

Die Vorrichtung und das Verfahren werden insbesondere bei der elektrolytischen Behandlung von Leiterplatten und Leiterfolien eingesetzt, die in einer horizontalen Transportebene in einer Durchlaufgalvanisieranlage geführt und dabei behandelt werden.

Die Vergleichmäßigung der Dicke der Metallschichten findet insbesondere bei der elektrolytischen Metallisierung (Galvanisierung) des Behandlungsgutes statt. Die Vorrichtung und das Verfahren sind aber auch bei der elektrolytischen Entmetallisierung bzw. beim elektrolytischen Ätzen von Metallschichten einsetzbar. Die nachfolgenden Ausführungen beziehen sich zwar ausschließlich auf die elektrolytische Metallisierung des Behandlungsgutes; für die Entmetallisierung bzw. das Ätzen der Metallschicht auf dem Behandlungsgut finden die Ausführungen jedoch sinngemäß Anwendung. Insbesondere werden die Gegenelektroden in diesem Fall als Kathoden und das Behandlungsgut als Anode geschaltet, während im Falle der Galvanisierung des Behandlungsgutes die Gegenelektroden als Anoden und das Behandlungsgut als Kathode geschaltet werden. In entsprechender Weise können die Gegenelektroden und das Behandlungsgut auch an eine Pulsstrom- oder Pulsspannungsquelle angeschlossen werden, beispielweise zur Erzeugung von mono- oder bipolaren Pulsströmen zwischen den Gegenelektroden und dem Behandlungsgut. In diesem Fall werden die Gegenelektroden kurzzeitig nacheinander anodisch und kathodisch und das Behandlungsgut umgekehrt gepolt.

Im Gegensatz zum Stand der Technik wird bei der erfindungsgemäßen Vorrichtung auf die Kunststoffumhüllung der Klammerteile völlig verzichtet, obwohl die Klammern fortwährend mit Elektrolytlösung in Kontakt stehen (Naßkontaktierung). Zur Vermeidung einer zu großen Raubkathodenwirkung durch die Klammern werden beide Klammerteile gegen die Anoden (Gegenelektroden), die sowohl löslich als auch unlöslich ausgeführt sein können, abgeschirmt. Eine der Abschirmungen befindet sich im Raum zwischen den unteren Anoden der Galvanisieranlage und den Klammerunterteilen. Die andere Abschirmung befindet sich im Raum zwischen den oberen Anoden und den Klammeroberteilen.

Bevorzugte Ausführungsformen der Erfindung sind in den Unteransprüchen angegeben.

Die Abschirmungen sind vorzugsweise im wesentlichen eben ausgebildet und im wesentlichen senkrecht zur Transportebene und parallel zur Transportrichtung des Behandlungsgutes in der Galvanisieranlage ausgerichtet.

Die Abschirmungen bestehen vorzugsweise aus einem elektrisch nichtleitenden Werkstoff, wie zum Beispiel Kunststoff oder Keramik. Sie können jedoch auch aus elektrisch leitfähigem Werkstoff bestehen, der an der Oberfläche mit einer Isolierbeschichtung oder mit einer anodischen Passivierungsschicht versehen ist, beispielsweise aus isolierbeschichtetem Metall oder aus einem an der Oberfläche anodisch passivierten Metall, wie zum Beispiel Titan.

Das Metall kann zur Vermeidung einer möglichen Zwischenleitergalvanisierung an das jeweilige obere bzw. untere Anodenpotential angeschlossen werden. Hierzu sind elektrisch leitfähige Verbindungen zwischen den aus elektrisch leitfähigem Werkstoff bestehenden Abschirmungen und den Anoden vorgesehen. Diese elektrisch leitfähige Verbindung zwischen den Abschirmungen und den Anoden kann aus Sicherheitsgründen einen elektrischen Widerstand aufweisen. Beispielsweise kann ein kurzschlußstrombegrenzender Widerstand eingefügt werden.

Die Abschirmungen erstrecken sich entlang des gesamten Transportweges im Galvanisierbereich der Durchlaufanlage. Zur Vermeidung eines Kurzschlusses sind elektrisch leitfähige Abschirmungen so befestigt, daß sich die Klammern und das Behandlungsgut im ungestörten Dauerbetrieb nicht berühren. Auch die Abschirmungen aus einem Isolator werden zur Vermeidung einer erfahrungsgemäß möglichen allmählichen Galvanisierung so justiert, daß sie weder die Behandlungsgutoberfläche noch die Klammerteile berühren.

Aus den vorgenannten Gründen sind die Abschirmungen gegen hindurchfließende Elektrolytlösung nicht vollkommen dicht. Daher werden die blanken Klammerteile im Bereich des Klammergreifpunktes, d.h. im Bereich des Behandlungsgutes, auch geringfügig galvanisiert. Der Einfluß dieser Metallabscheidung auf die Schichtdickenverteilung der Leiterplatten im Bereich der Klammergreifpunkte ist jedoch gering. Dies bedeutet in der Praxis, daß nur noch ein schmaler Randstreifen der Leiterplatten technisch nicht nutzbar ist. Wichtig für die Reproduzierbarkeit präziser Galvanisierergebnisse in Durchlaufanlagen ist, daß im Bereich der Greifpunkte leicht metallisierte Klammern bei jedem Rücklauf vollständig elektrolytisch entmetallisiert und gereinigt werden.

Da die Klammer nicht mit einem Kunststoffüberzug versehen sind, hat jede Metallabscheidung auf den Klammern eine ideale elektrisch leitfähige Verbindung zur Entmetallisierungsstromquelle. Ein temporäres Abreißen dieser Verbindung, so wie es bei kunststoffumhüllten Klammerteilen vorkommt und daher zu Abscheidungen auf den Teilen bis zu deren Unbrauchbarkeit führt, kann hier nicht auftreten. Am Einlauf der Durchlaufgalvanisieranlage steht daher immer eine vollkommen elektrolytisch geätzte, d.h. gereinigte, Klammer zur Verfügung.

Der vollständige Verzicht auf eine Kunststoffumhültung der Klammerteile ist des weiteren auch in Bezug auf die Kosten und auf die Standzeit der Klammern vorteilhaft. Die blanke Klammer ist kostengünstig herstellbar, und die Standzeit ist nahezu unbegrenzt.

Die untere Klammerhälfte befindet sich mit ihrer Kontaktstelle immer auf dem konstanten Niveau der unteren Seiten der in der Transportebene geführten Leiterplatten. Daher kann die untere Abschirmung sehr genau an die Leiterplattenunterseite herangeführt werden. Bei einem realisierbaren Abstand der Abschirmung zur Leiterplattenunterseite und zum Klammerunterteil von etwa je 1 mm kann eine nahezu vollständige Abschirmung des elektrischen Feldes am Ort des Klammerunterteils realisiert werden.

Unterschiedliche Leiterplattendicken werden dadurch ausgeglichen, daß die Klammeroberteile verschiebbar ausgeführt sind. Die obere Abschirmung muß daher von der Leiterplattenoberseite soweit entfernt angeordnet werden, daß bei den dicksten zu transportierenden Leiterplatten noch ein Sicherheitsabstand von der Leiterplattenoberseite zur Abschirmung ebenfalls von etwa 1 mm vorhanden ist. Dies bedeutet, daß bei einer maximalen Leiterplattendicke von 8 mm der Abstand der oberen Abschirmung vom Nullniveau (Niveau der Leiterplattenunterseite) 9 mm betragen muß. Wegen dieses relativ großen Abstandes wird bei der Bearbeitung von Folien mit einer Dicke von zum Beispiel 0,1 mm in nicht zu vernachlässigendem Umfang Metall auf dem Klammeroberteilen abgeschieden. Infolge der damit verbundenen größeren Raubkathodenwirkung des Klammeroberteils kann ein entsprechend größerer Randbereich bei Leiterfolien nicht genutzt werden. Mit zunehmender Leiterplattendicke verringert sich infolge der zunehmenden Abschirmung der nicht nutzbare Randbereich der Leiterplatten. Werden in einer Galvanisieranlage Leiterfolien oder Leiterplatten mit nur geringen Unterschieden in der Dicke oder nur mit einer einzigen Dicke produziert, so kann auch die obere Abschirmung sehr genau auf die Behandlungsgutdicke eingestellt werden. In der Praxis kommt dieser Fall einer Monofertigung überwiegend vor. Der nicht nutzbare Randbereich des Behandlungsgutes ist in diesem Falle minimal.

Werden in einer Galvanisieranlage dagegen abwechselnd Folien, Leiterplatten und Multilayer bis zu einer Dicke von beispielsweise 8 mm produziert, und soll zugleich der nutzbare Bereich der Folien und Platten bis zur maximal möglichen Grenze erweitert werden, so wird jedes metallisch blanke Klammeroberteil mit einer mitfahrenden Blende ausgerüstet, die am Klammeroberteil befestigt ist. Die Blende ist im wesentlichen parallel zum Klammeroberteil ausgerichtet und reicht so nahe an die Transportebene, in der die Leiterplatten oder -folien geführt werden, heran, daß die Blenden das in der Transportebene geführte Behandlungsgut und die Kontaktstelle gerade noch nicht berühren können.

Die Blende besteht aus einem elektrisch nichtleitenden Werkstoff, wie zum Beispiel Keramik oder Kunststoff. Sie ist am Klammeroberteil in einem größeren Abstand zur Klammerkontaktstelle befestigt. Am Befestigungspunkt besteht infolge der oberen Abschirmung nahezu kein elektrisches Feld. Damit wird der Auftrag einer metallischen Schicht auf dem Kunststoff ausgeschlossen. Die Blende reicht von der Befestigungsstelle freitragend bis zur Kontaktstelle hinunter. Durch die Befestigung am Klammeroberteil führt sie alle Öffnungs- und Schließbewegungen des Klammeroberteils mit aus. Der Abstand der Blende zur Behandlungsgutoberseite wird ebenso eingestellt wie die der unteren Abschirmung zur Behandlungsgutunterseite. Die Blende berührt also nicht die Behandlungsgutoberfläche und auch nicht die Kontaktstelle der Klammer.

Die Breite der Blenden (Abmessung der Blenden in Transportrichtung des Behandlungsgutes in der Galvanisieranlage gesehen) entspricht etwa dem Abstand von einer Klammer zur benachbarten Klammer. Zur Verbesserung der Abdichtung können sich die Blenden benachbarter Klammern auch gegenseitig überlappen. Zwischen den Blenden und den oberen Anodenkörben wird des weiteren die beschriebene statische Abschirmung mit dem gebotenen kollisionsvermeidenden Abstand angeordnet. Mit den zusätzlichen Blenden verringert sich der technisch nicht nutzbare Randstreifen eines Behandlungsgutes im Klammerbereich auf 12 Millimeter. Diese Streifenbreite ist unabhängig von der Dicke des Gutes und immer gleich groß.

Ferner können an den Blenden oder an den oberen Abschirmungen weitere im wesentlichen horizontal ausgerichtete obere Blenden und an den unteren Abschirmungen im wesentlichen horizontal ausgerichtete untere Blenden befestigt sein. Diese dienen dazu, die Schichtdickenverteilung im Randbereich des Behandlungsgutes weiter zu vergleichmäßigen, da sich die elektrischen Feldlinien in Randbereichen elektrisch leitfähiger Gegenstände grundsätzlich konzentrieren und dort zu höheren Metallschichtdicken führen. Zur weiteren vorteilhaften Beeinflussung der Verteilung der Metallschichtdicke auf dem Behandlungsgut sind ferner Durchbrüche in den horizontal ausgerichteten Blenden vorgesehen.

Vorzugsweise sind die Kontaktierstellen an den oberen und unteren Klammerteilen für die elektrische Kontaktierung des Behandiungsgutes an den äußersten Enden der Klammerteile angeordnet.

Die Erfindung wird nachfolgend an Hand der Figuren 1 bis 5 weiter erläutert. Es zeigen
- Figur 1 a:: einen Ausschnitt aus einer schematischen Querschnittsdarstellung durch eine horizontale Durchlaufgalvanisieranlage, in Transportrichtung gesehen, mit Abschirmungen und mit einer eine Folie greifenden Klammer;
- Figur 1b:: eine Querschnittsansicht einer eine Leiterplatte mit großer Dicke greifenden Klammer;
- Figur 2a:: eine Ansicht wie in Figur 1a der Anlage mit einer Klammer mit zusätzlicher Blende;
- Figur 2b:: eine Ansicht wie in Figur 1 b der Anlage mit einer Klammer mit zusätzlicher Blende;
- Figur 3:: eine Vorderansicht von am Klammeroberteil befestigten Blenden;
- Figur 4:: eine Ansicht wie in Figur 1b der Anlage mit einer Klammer mit zusätzlichen horizontalen Blenden;
- Figur 5:: einen schematischen Querschnitt durch den oberen Bereich einer horizontalen Durchlaufgalvanisieranlage nach dem Stand der Technik.

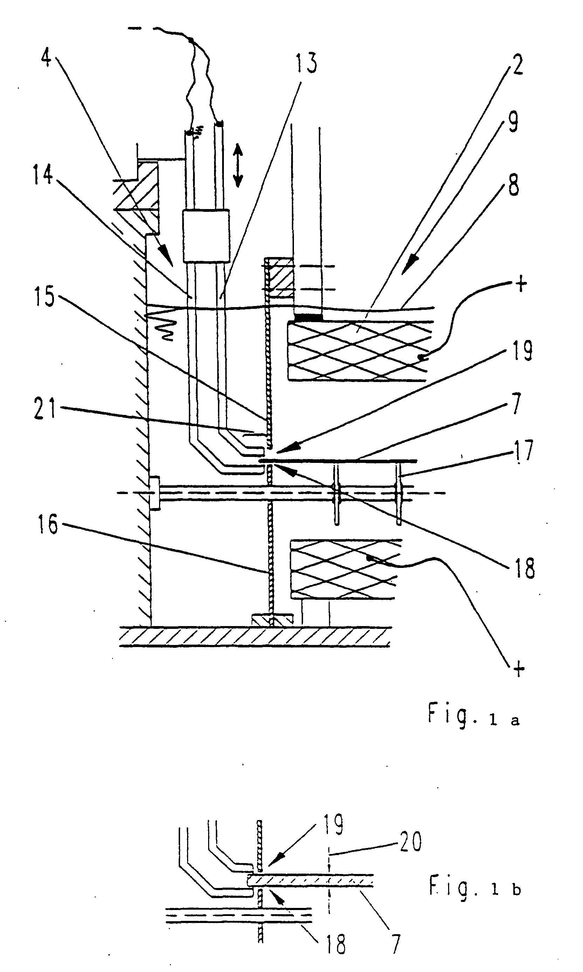

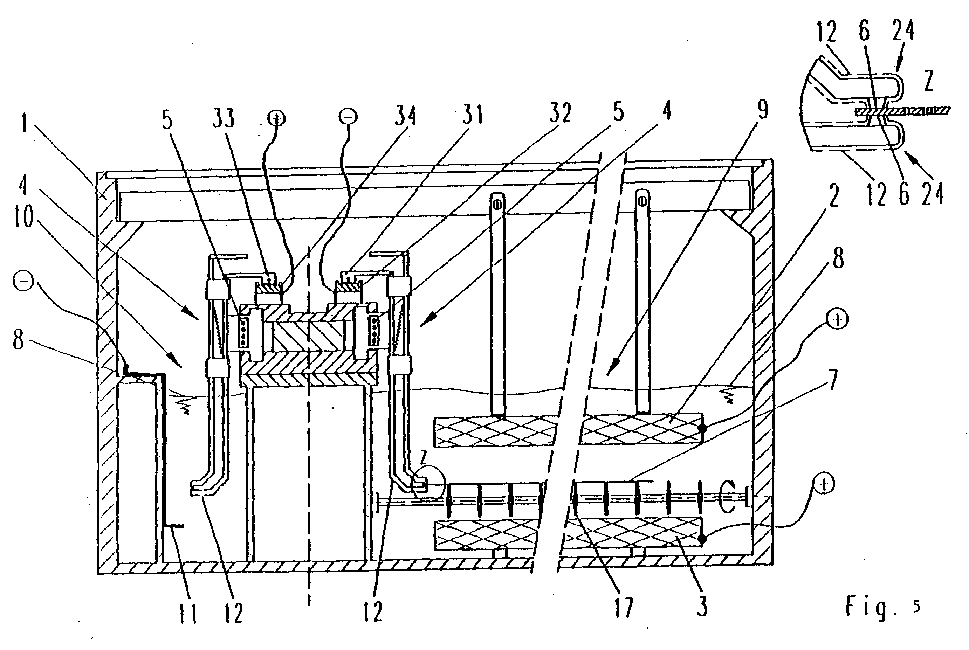

Eine herkömmliche Galvanisieranlage ist in Figur 5 dargestellt. Im Arbeitsbehälter 1 befinden sich obere Anodenkörbe 2 und untere Anodenkörbe 3. Eine reale sechs Meter lange Durchlaufgalvanisieranlage besteht zum Beispiel aus fünfundzwanzig oberen und fünfundzwanzig unteren Anodenkörben. Diese sind hintereinander in Transportrichtung des Behandlungsgutes, beispielsweise Leiterplatten, angeordnet. Bei der Ansicht in Figur 1, in Transportrichtung gesehen, sind daher nur ein oberer und ein unterer Anodenkorb erkennbar. Desgleichen liegen die Klammern 4 in der Figur hintereinander. Der Abstand von Klammer zu Klammer beträgt zum Beispiel 60 mm. Die Klammern 4 sind an einem motorisch angetriebenen endlos umlaufenden Transportband 5 befestigt. Die Klammern 4 greifen das Behandlungsgut 7 an der Klammerkontaktstelle 6 (Ausschnitt Z). Sie führen und transportieren es durch die Galvanisieranlage. Der Arbeitsbehälter 1 ist mit Elektrolyt befüllt. Der Badspiegel 8 liegt über den oberen Anodenkörben 2. Im rechten Teil der Figur 1 befindet sich der Galvanisierbereich 9 und im linken Teil der Entmetallisierungsbereich 10. In beiden Bereichen befindet sich dieselbe Elektrolytflüssigkeit. Die Anoden, hier in Form von Körben 2,3, sind mit löslichem Anodenmetall befüllt. Die Anoden 2,3 und das Behandlungsgut 7 bilden zusammen die Galvanisierzellen. Die Klammern 4 und die Kathoden 11 im Entmetallisierungsbereich bilden zusammen die Entmetallisierungszelle. Die Potentiale aller Elektroden sind in Figur 5 zusätzlich angegeben. Über Schleifkontakte 31 wird das Kathodenpotential für die Metallisierung über die Schleifschiene 32 an die Klammern 4 und von dort an das Behandlungsgut 7 angelegt. Über weitere Schleifkontakte 33 wird das Anodenpotential für die Entmetallisierung an die zu entmetallisierenden Klammern 4 im Entmetallisierungsbereich 9 angelegt.

Die Klammern 4 sind bis weit über den Badspiegel 8 hinaus mit einer Kunststoffumhüllung 12 überzogen (Ausschnitt Z). Nur die Klammerkontaktstellen 6 sind metallisch blank. Diese werden im Galvanisierbereich 9 ebenso galvanisiert wie das Behandlungsgut 7. Ferner wird hier die Klammer-Kunststoffumhüllung, wie oben beschrieben, galvanisiert. Im Entmetallisierungsbereich 10 werden die Klammerkontaktstellen 6 wieder entmetallisiert. Die Metallschicht auf der Kunststoffumhüllung wird durch Entmetallisierung dagegen nur teilweise wieder entfernt. Dies führt nach längerer Betriebszeit zur Unbrauchbarkeit dieser an sich bekannten Klammern.

Zur Vermeidung dieses Ausfalles dient die in Figur 1a und 1b dargestellte erfindungsgemäße Anordnung. Die Klammern 4 bestehen aus metallisch blankem Werkstoff, zum Beispiel aus Titan. Es entfällt also die Kunststoffumhüllung. Diese Klammern ergreifen das Behandlungsgut 7 und führen es durch den Galvanisierbereich 9 der Durchlaufgalvanisieranlage. Zur Vermeidung der Galvanisierung der Klammeroberteile 13 und der Klammerunterteile 14 ist eine obere Abschirmung 15 zwischen dem oberen Anodenkorb 2 und der Klammer 4 eingefügt. In entsprechender Weise ist unterhalb des Behandlungsgutes eine untere Abschirmung 16 in das vom unteren Anodenkorb zum Klammerunterteil 14 führende elektrische Feld eingefügt. Die Abschirmungen 15,16 erstrecken sich entlang des gesamten Transportweges im Galvanisierbereich 9 der Galvanisieranlage.

Die untere Abschirmung 16 reicht bis dicht an die Behandlungsgutoberfläche heran. Das Niveau der Unterseite des Behandlungsgutes wird von den angetriebenen Stützrollen 17 vorgegeben und ist damit konstant. Somit kann der Sicherheitsabstand 18 zwischen dem oberen Ende der Abschirmung 16 und der unteren Behandlungsgutoberfläche auch konstant und klein gehalten werden. Die Achse der Stützrollen 17 wird durch ein Loch der unteren Abschirmung 16 geführt. Die Achse kann auch in dieser Abschirmung gelagert sein. Der obere Abstand 19 zwischen dem unteren Ende der Abschirmung 15 und der oberen Behandlungsgutoberfläche muß so groß gewählt werden, daß als Sicherheitsabstand bei zu produzierendem Behandlungsgut mit der größten Dicke 20 auch noch ein Wert eingehalten wird, der dem unteren Abstand 18 entspricht. Diese Situation ist ausschnittsweise in Figur 1b dargestellt.

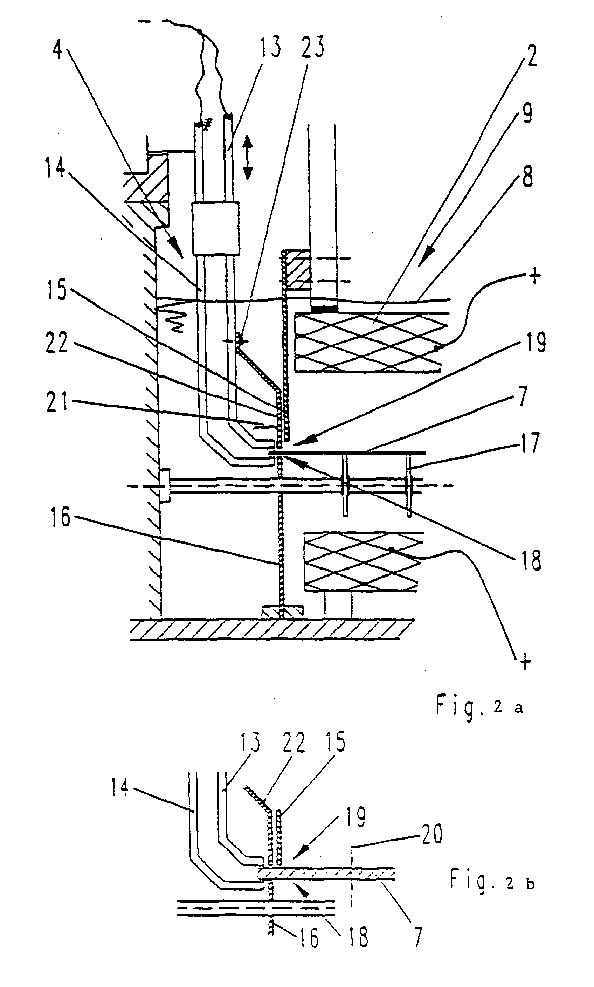

Elektrische Feldlinien des elektrischen Feldes der oberen Anode greifen durch die Lücke 19 zwischen dem unteren Ende der oberen Abschirmung 15 und dem Behandlungsgut 7 hindurch und treffen auf den unteren Bereich der Klammer 4, wenn dort wegen der Bearbeitung von dünnen Folien ein größerer Abstand besteht. Die Folge ist eine abstandsbedingte Galvanisierung eines Bereiches 21 auf der metallisch blanken Klammer. Zur Vermeidung dieser Galvanisierung wird die in den Figuren 2a und 2b dargestellte Blende 22 am Klammeroberteil 13 befestigt.

Die Blende 22 besteht aus einem elektrisch nichtleitenden Werkstoff. Sie berührt die Klammer in deren unterem Bereich nicht. Damit wird vermieden, daß der Kunststoff der Blende, wie oben beschrieben, möglicherweise galvanisiert wird. Die Befestigungsstelle 23 am Klammeroberteil 13 soll so positioniert sein, daß die Elektrolytstrecke von der Stelle zum oberen Anodenkorb 2 möglichst lang ist, um auch auf Dauer eine Metallisierung der Blende 22 zu vermeiden. Die Befestigungsstelle 23 kann unter oder über dem Badspiegel liegen. Liegt sie unterhalb des Badspiegels, so werden die Feldlinien, die von der Anode ausgehen, durch die obere Abschirmung 15 von der Befestigungsstelle 23 ferngehalten. Damit wird das mögliche Aufwachsen einer Galvanisierschicht vom metallisch blanken Klammeroberteil 13 auf die Blende 22 auch dann sicher vermieden, wenn sich die Befestigungsstelle und damit die Blende unterhalb des Badspiegels 8 befindet.

Indem die Blende durch die Befestigung am Klammeroberteil mit dessen Bewegung immer mitgenommen wird, stellt sich automatisch immer ein minimaler Sicherheitsabstand der Blende zum Behandlungsgut ein, der ebenso klein ist wie der Abstand 18 an der Unterseite. Damit wird eine sehr gleichmäßige Schichtdickenverteilung auf beiden Seiten des Behandlungsgutes bis in den Randbereich hinein erzielt.

Indem die Klammern ferner metallisch blank und nicht mit einer Kunststoffisolierung versehen sind, ergibt sich eine vorteilhaftere Ausführung der Klammerkontaktstellen. Die in Figur 5 erkennbaren isolierten Überstände 24 über die Klammerkontaktstellen 6 entfallen hier vollständig. In der erfindungsgemäßen Ausführungsform liegen die Klammerkontaktstellen am äußeren Ende der Klammerteile (in Richtung zum nutzbaren Bereich des Behandlungsgutes 7), so daß die Abschirmungswirkung der Klammern am Behandlungsgut noch weiter minimiert wird. Der nicht nutzbare Klammerrand erreicht insbesondere dann ein Minimum, wenn zugleich auch die Abschirmungen 15,16 und die Blende 22 in Behandlungsgutnähe sehr dünn ausgebildet werden. Hierfür eignet sich insbesondere die Ausführung der Abschirmung aus einem passivierten oder beschichteten Metall.

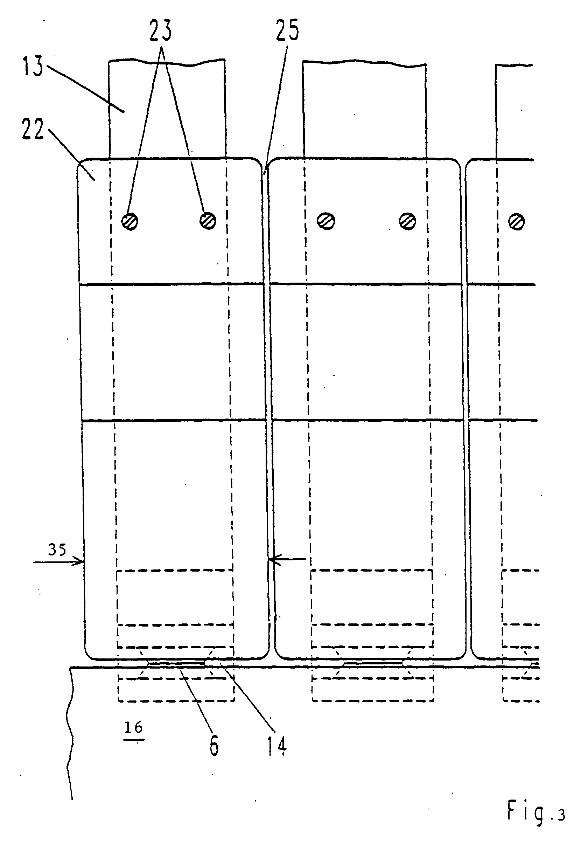

In Figur 3 sind Klammern mit befestigten Blenden 22 in der Vorderansicht ohne Behandlungsgut, beispielsweise Leiterplatten, dargestellt. Die Ansicht stellt einen Ausschnitt der Anlage in Seitenansicht dar, d.h. die Transportrichtung für das Behandlungsgut verläuft in der Figur von links nach rechts oder von rechts nach links. Da kein Behandlungsgut dargestellt ist, berühren die Klammeroberteile und die Klammerunterteile einander an den Kontaktstellen. Die Blenden weisen eine Breite 35 auf. Die untere Klammerkontaktstelle 6 wird von der unteren feststehenden Abschirmung 16 abgeschirmt. Zwischen zwei Blenden 22 an benachbarten Klammern bildet sich ein Blendenspalt 25. Dieser sollte zur Vermeidung einer Klammergalvanisierung möglichst klein sein. In einer nicht dargestellten Ausführungsform können sich die Blenden 22 auch gegenseitig überlappen. Damit wird der Spalt geschlossen. Die Schichtdickenverteilung des Behandlungsgutes soll bis auf einen schmalen Randbereich des Behandlungsgutes eine vorgegebene Toleranz einhalten. Bekannt ist, daß im Randbereich des Behandlungsgutes eine Feldlinienkonzentratior auftritt. Die metallisch blanke Klammer stellt durch die Sicherheitsabstände zwischen den Abschirmungen bzw. der Blende und den Behandlungsgutoberflächen hindurch nur noch eine schwach wirkende Raubkathode dar. Die Folge davon ist ein Schichtdickenanstieg auf dem Behandlungsgut in der Nähe der Blende 22 sowie der Abschirmungen 15,16.

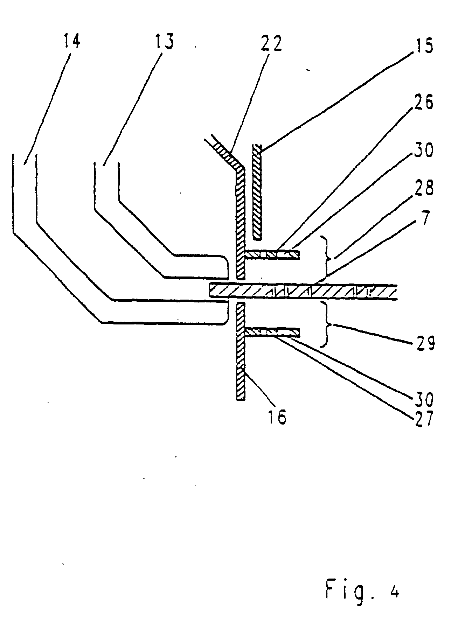

Diesem Anstieg wird durch Blenden, die im betroffenen Randbereich des Behandlungsguts zwischen diesem und den Anoden horizontal eingefügt sind, begegnet. Besonders wirksam sind Blenden, die nahe an der Oberfläche des Gutes angeordnet sind. In Figur 4 sind derartige horizontale Blenden 26,27 dargestellt. Sie sind oben an der Blende 22 und unten an der Abschirmung 16 befestigt. Die Blende 22 ist am senkrecht beweglichen Klammeroberteil 13 befestigt. Damit wird die obere Lücke, über die Feldlinien in den Raum hinter der Abschirmung 15 und den Blenden 22,26 eindringen können, klein und insbesondere konstant gehalten. Damit ist auch der Abstand 28 zwischen der horizontalen Blends 26 und der Behandlungsgutoberseite konstant. Gleiches gilt für die Lücke zwischen der Abschirmung 16 bzw. der Blende 27, da der untere Abstand zwischen der Oberkante der unteren Abschirmung 16 und der Behandlungsgutunterseite ohnehin konstant ist, so daß die fest montierten horizontalen Blenden 27 einen konstanten Abstand 29 zur Behandlungsgutunterseite haben.

Die untere Blende 27 kann in Transportrichtung durchgehend montiert werden. Oben entspricht die Länge der mitfahrenden Blenden 22 dem Klammerabstand zuzüglich einer möglichen Überlappung der Blenden. Die Blenden 26,27 werden vorzugsweise mit Durchbrüchen 30 versehen. Mittels dieser Durchbrüche werden auf den Oberflächen des Behandlungsgutes 7 die Schichtdickenverteilungen so beeinflußt, daß die Metallschichtdicken gleichmäßig bis zur Blende 22 beziehungsweise bis zur Abschirmung 16 verlaufen. Bei Gaivanisieranlagen mit Klammern ohne Blenden 22 kann die obere horizontale Blende 26 auch an der oberen Abschirmung 15 befestigt werden.

### Bezugszeichenliste:

- 1: Arbeitsbehälter
- 2: oberer Anodenkorb
- 3: unterer Anodenkorb
- 4: Klammer
- 5: endloses Transportband
- 6: Klammerkontaktstelle
- 7: Behandlungsgut
- 8: Badspiegel
- 9: Galvanisierbereich
- 10: Entmetallisierbereich
- 11: Entmetallisierkathode
- 12: Kunststoffumhüllung
- 13: Klammeroberteil
- 14: Klammerunterteil
- 15: obere Abschirmung
- 16: untere Abschirmung
- 17: Stützrollen
- 18: unterer Abstand (= Sicherheitsabstand)
- 19: oberer Abstand
- 20: Dicke des Behandlungsgutes
- 21: Bereich der Klammergalvanisierung
- 22: Blende
- 23: Befestigungsstelle
- 24: isolierter Überstand
- 25: Blendenspalt
- 26: obere horizontale Blende
- 27: untere horizontale Blende
- 28: oberer Blendenabstand
- 29: unterer Blendenabstand
- 30: Durchbrüche
- 31: Schleifkontakt kathodisch
- 32: Schleifschiene kathodisch
- 33: Schleifkontakt anodisch
- 34: Schleifschiene anodisch
- 35: Breite der Blenden 22

## Patentansprüche

1. Vorrichtung zum Vergleichmäßigen der Dicke von Metallschichten an elektrischen Kontaktierstellen auf flachem Behandlungsgut, wie Leiterfolien und Leiterplatten, bei der elektrolytischen Behandlung des in einer horizontalen Transportebene in einer Durchlaufgalvanisieranlage geführten Behandlungsgutes, die
a. der Transportebene gegenüberliegende Gegenelektroden,
b. an einem endlos umlaufenden Transportmittel befestigte Klammern zum Kontaktieren des Behandlungsgutes, wobei die Klammern jeweils ein Klammerunterteil und ein Klammeroberteil aufweisen,
i. die elektrisch leitfähig sind,
ii. an der Oberfläche aus Metall bestehen,
iii. relativ zueinander beweglich sind und
iv. jeweils mindestens eine Kontaktstelle für das Behandlungsgut aufweisen, sowie
c. mindestens eine Stromquelle zum Erzeugen eines Stromflusses zwischen den Gegenelektroden und den Klammern aufweist,
**dadurch gekennzeichnet, daß** zwischen den Gegenelektroden (2,3) und den Klammern (4) obere und untere Abschirmungen (15,16) für das elektrische Feld angeordnet sind, die so nahe an die Transportebene heranreichen, daß das in der Transportebene geführte Behandlungsgut und die Klammerteile (13,14) von den Abschirmungen gerade noch nicht berührt werden können.

2. Vorrichtung nach Anspruch 1, **dadurch gekennzeichnet, daß** die Abschirmungen (15,16) im wesentlichen eben ausgebildet und im wesentlichen senkrecht zur Transportebene und parallel zur Transportrichtung des Behandlungsgutes in der Galvanisieranlage ausgerichtet sind.

3. Vorrichtung nach einem der vorstehenden Ansprüche, **dadurch gekennzeichnet, daß** die Abschirmungen (15,16) aus einem elektrisch leitfähigen Werkstoff bestehen, der an der Oberfläche mit einer lsolierbeschichtung oder mit einer anodischen Passivierungsschicht versehen ist, oder daß die Abschirmungen (15,16) aus einem elektrisch nichtleitenden Werkstoff bestehen.

4. Vorrichtung nach Anspruch 3, **dadurch gekennzeichnet, daß** elektrisch leitfähige Verbindungen zwischen den aus elektrisch leitfähigem Werkstoff bestehenden Abschirmungen (15,16) und den Gegenelektroden (2,3) vorgesehen sind.

5. Vorrichtung nach Anspruch 4, **dadurch gekennzeichnet, daß** die elektrisch leitfähigen Verbindungen zwischen den Abschirmungen (15,16) und den Gegenelektroden (2,3) einen elektrischen Widerstand aufweisen.

6. Vorrichtung nach einem der vorstehenden Ansprüche, **dadurch gekennzeichnet, daß** an den Klammeroberteilen (13) Blenden (22) befestigt sind, die im wesentlichen parallel zum Klammeroberteil ausgerichtet sind und so nahe an die Transportebene und an die Kontaktstelle (6) heranreichen, daß die Blenden das in der Transportebene geführte Behandlungsgut und die Kontaktstelle gerade noch nicht berühren können.

7. Vorrichtung nach Anspruch 6, **dadurch gekennzeichnet, daß** die Blenden (22), in Transportrichtung des Behandlungsgutes in der Galvanisieranlage gesehen, eine Breite aufweisen, die dem Abstand der Klammern voneinander entspricht, oder so breit sind, daß benachbarte Blenden einander überlappen.

8. Vorrichtung nach einem der vorstehenden Ansprüche, **dadurch gekennzeichnet, daß** an den Blenden (22) oder an den oberen Abschirmungen (15) weitere im wesentlichen horizontal ausgerichtete obere Blenden (26) und an den unteren Abschirmungen (16) im wesentlichen horizontal ausgerichtete untere Blenden (27) befestigt sind.

9. Vorrichtung nach Anspruch 8, **dadurch gekennzeichnet, daß** zur Beeinflussung der Verteilung der Metallschichtdicke auf dem Behandlungsgut Durchbrüche (30) in den horizontal ausgerichteten Blenden (26,27) vorgesehen sind.

10. Vorrichtung nach einem der vorstehenden Ansprüche, **dadurch gekennzeichnet, daß** die Kontaktstellen (6) zur elektrischen Kontaktierung des Behandlungsgutes an den äußersten Enden der Klammerteile (13,14) angeordnet sind.

11. Verfahren zum Vergleichmäßigen der Dicke von Metallschichten an elektrischen Kontaktierstellen auf flachem Behandlungsgut, wie Leiterfolien und Leiterplatten, bei der elektrolytischen Behandlung des in einer horizontalen Transportebene in einer Durchlaufgalvanisieranlage geführten Behandlungsgutes, bei dem
a. der Transportebene gegenüberliegende Gegenelektroden,
b. an einem endlos umlaufenden Transportmittel befestigte und jeweils ein Klammerunterteil und ein Klammeroberteil aufweisende Klammern zum Kontaktieren des Behandlungsgutes, wobei die Klammern
i. elektrisch leitfähig sind,
ii. an der Oberfläche aus Metall bestehen,
iii. relativ zueinander beweglich sind und
iv. jeweils mindestens eine Kontaktstelle für das Behandlungsgut aufweisen, sowie
c. mindestens eine Stromquelle zum Erzeugen eines Stromflusses zwischen den Gegenelektroden und den Klammern
vorgesehen werden,
**dadurch gekennzeichnet, daß** zwischen den Gegenelektroden (2,3) und den Klammern (4) obere und untere Abschirmungen (15,16) für das elektrische Feld angeordnet werden, die so nahe an die Transportebene heranreichen, daß das in der Transportebene geführte Behandlungsgut und die Klammerteile (13,14) von den Abschirmungen gerade noch nicht berührt werden.

12. Verfahren nach Anspruch 11, **dadurch gekennzeichnet, daß** die Dicke der Metallschichten bei der elektrolytischen Metallisierung des Behandlungsgutes vergleichmäßigt wird und daß die Gegenelektroden als Anoden und das Behandlungsgut als Kathode geschaltet wird.

## Claims

1. Apparatus for distributing evenly the thickness of metal layers at electrical contacting locations on flat material to be treated, such as conductor foils and printed circuit boards, during the electrolytic treatment of the material to be treated, which is guided in a horizontal plane of conveyance in a continuous electroplating system, which apparatus includes
a. counter-electrodes situated opposite the plane of conveyance,
b. clamps, which are mounted on an endlessly circulating conveyor means, for contacting the material to be treated, the clamps each including a lower clamp portion and an upper clamp portion,
i. which portions are electrically conductive,
ii. are formed from metal on the surface,
iii. are displaceable relative to each other, and
iv. each include at least one contact point for the material to be treated,
and
c. at least one source of current to produce a flow of current between the counter-electrodes and the clamps,
**characterised in that** upper and lower protective screens (15,16) for the electrical field are disposed between the counter-electrodes (2,3) and the clamps (4) and extend so closely to the plane of conveyance that the material to be treated, which is guided in the plane of conveyance, and the clamp portions (13,14) cannot yet be in contact with the protective screens.

2. Apparatus according to claim 1, **characterised in that** the protective screens (15,16) are substantially flat and are orientated substantially perpendicularly relative to the plane of conveyance and parallel to the direction of conveyance of the material to be treated in the electroplating system.

3. Apparatus according to one of the preceding claims, **characterised in that** the protective screens (15,16) are formed from an electrically conductive material, which is provided on the surface with an insulating coating or with an anodic passivation layer, or **in that** the protective screens (15,16) are formed from an electrically non-conductive material.

4. Apparatus according to claim 3, **characterised in that** electrically conductive connections are provided between the protective screens (15,16), formed from electrically conductive material, and the counter-electrodes (2,3).

5. Apparatus according to claim 4, **characterised in that** the electrically conductive connections between the protective screens (15,16) and the counter-electrodes (2,3) have an electrical resistance.

6. Apparatus according to one of the preceding claims, **characterised in that** plates (22) are mounted on the upper clamp portions (13), which plates are orientated substantially parallel to the upper clamp portion and extend so closely to the plane of conveyance and to the contact point (6) that the plates cannot yet be in contact with the material to be treated, which is guided in the plane of conveyance, and with the contact point.

7. Apparatus according to claim 6, **characterised in that**, when viewed with respect to the direction of conveyance of the material to be treated in the electroplating system, the plates (22) have a width which corresponds to the spacing between the clamps, or they are so wide that adjacent plates overlap one another.

8. Apparatus according to one of the preceding claims, **characterised in that** additional upper plates (26), which are orientated substantially horizontally, are mounted on the plates (22) or on the upper protective screens (15), and lower plates (27), which are orientated substantially horizontally, are mounted on the lower protective screens (16).

9. Apparatus according to claim 8, **characterised in that**, to influence the distribution of the metal layer thickness on the material to be treated, openings (30) are provided in the horizontally orientated plates (26,27).

10. Apparatus according to one of the preceding claims, **characterised in that** the contact points (6) are disposed at the outermost ends of the clamp portions (13,14) for the electrical contacting of the material to be treated.

11. Method of distributing evenly the thickness of metal layers at electrical contacting locations on flat material to be treated, such as conductor foils and printed circuit boards, during the electrolytic treatment of the material to be treated, which is guided in a horizontal plane of conveyance in a continuous electroplating system, wherein
a. counter-electrodes are provided, which are situated opposite the plane of conveyance,
b. clamps are provided for contacting the material to be treated, said clamps being mounted on an endlessly circulating conveyor means and each including a lower clamp portion and an upper clamp portion, the clamps
i. being electrically conductive,
ii. being formed from metal on the surface,
iii. being displaceable relative to one another, and
iv. each including at least one contact point for the material to be treated,
and
c. at least one source of current is provided to produce a flow of current between the counter-electrodes and the clamps,
**characterised in that** upper and lower protective screens (15,16) for the electrical field are disposed between the counter-electrodes (2,3) and the clamps (4) and extend so closely to the plane of conveyance that the material to be treated, which is guided in the plane of conveyance, and the clamp portions (13,14) are not yet in contact with the protective screens.

12. Method according to claim 11, **characterised in that** the thickness of the metal layers during the electrolytic metallisation of the material to be treated is distributed evenly, and **in that** the counter-electrodes are connected as the anodes and the material to be treated is connected as the cathode.

## Revendications

1. Dispositif pour égaliser l'épaisseur de couches métalliques au niveau des points de mise en contact électrique sur un produit plat à traiter, tel que des feuilles conductrices et des circuits imprimés, lors du traitement électrolytique du produit à traiter guidé sur un niveau de transport horizontal dans une installation de galvanisation continue, qui comprend
a. des contre-électrodes opposées au niveau de transport,
b. des agrafes fixées sur un moyen de transport sans fin pour effectuer la mise en contact du produit à traiter, les agrafes comprenant respectivement une partie inférieure et une partie supérieure
i. qui présentent une conductibilité électrique,
ii. dont la partie supérieure est en métal,
iii. qui sont mobiles l'une par rapport à l'autre et
iv. qui présentent respectivement au moins un point de contact pour le produit à traiter, ainsi que
c. au moins une source de courant pour produire un flux de courant entre les contre-électrodes et les agrafes,
**caractérisé en ce qu'**entre les contre-électrodes (2,3) et les agrafes (4) sont disposés des écrans supérieurs et inférieurs (15,16) pour le champ électrique, qui s'approchent suffisamment du niveau de transport pour que le produit à traiter guidé au niveau de transport et les parties d'agrafes (13,14) puissent juste ne pas encore être touchés par les écrans.

2. Dispositif selon la revendication 1, **caractérisé en ce que** les écrans (15,16) sont réalisés de manière sensiblement plane et sont pour l'essentiel perpendiculaires au niveau de transport et parallèles à la direction de transport du produit à traiter dans l'installation de galvanisation.

3. Dispositif selon l'une des revendications précédentes, **caractérisé en ce que** les écrans (15,16) se composent d'un matériau présentant une conductibilité électrique et qui est muni à sa surface d'une couche isolante ou d'une couche de passivation anodique ou **en ce que** les écrans (15,16) se composent d'un matériau ne présentant pas de conductibilité électrique.

4. Dispositif selon la revendication 3, **caractérisé en ce que** des liaisons à conductibilité électrique sont prévues entre les écrans (15,16) se composant de matériau présentant une conductibilité électrique et les contre-électrodes (2,3).

5. Dispositif selon la revendication 4, **caractérisé en ce que** les liaisons présentant une conductibilité électrique entre les écrans (15,16) et les contre-électrodes (2,3) ont une résistance électrique.

6. Dispositif selon l'une des revendications précédentes, **caractérisé en ce que** sur les parties supérieures des agrafes (13) sont fixés des panneaux d'obturation (22) qui sont disposés sensiblement parallèlement à la partie supérieure des agrafes et qui s'approchent suffisamment près du niveau de transport et du point de contact (6) pour que les panneaux d'obturation puissent juste ne pas encore toucher le produit à traiter guidé au niveau de transport et le point de contact.

7. Dispositif selon la revendication 6, **caractérisé en ce que**, vu en direction de transport du produit à traiter dans l'installation de galvanisation, les panneaux d'obturation (22) ont une largeur qui correspond à l'espacement entre les agrafes ou sont suffisamment larges pour que les panneaux d'obturation voisins se recouvrent mutuellement.

8. Dispositif selon l'une des revendications précédentes, **caractérisé en ce que** sur les panneaux d'obturation (22) ou sur les écrans supérieurs (15) sont fixés d'autres panneaux d'obturation supérieurs (26) dirigés sensiblement à l'horizontale et **en ce que** sur les écrans inférieurs (16) sont fixés des panneaux d'obturation inférieurs (27) dirigés sensiblement à l'horizontale.

9. Dispositif selon la revendication 8, **caractérisé en ce que** pour influencer la répartition de l'épaisseur de la couche de métal sur le produit à traiter des ouvertures (30) sont prévues sur les panneaux d'obturation disposés horizontalement (26,27).

10. Dispositif selon l'une des revendications précédentes, **caractérisé en ce que** les points de contact (6) pour la mise en contact électrique du produit à traiter sont disposés aux embouts extrêmes des parties d'agrafes (13,14).

11. Procédé pour égaliser l'épaisseur de couches métalliques au niveau des points de mise en contact électrique sur un produit plat à traiter, tel que des feuilles conductrices et des circuits imprimés, lors du traitement électrolytique du produit à traiter guidé sur un niveau de transport horizontal dans une installation de galvanisation continue, avec lequel sont prévus:
a. des contre-électrodes opposées au niveau de transport,
b. des agrafes fixées sur un moyen de transport sans fin et comprenant respectivement une partie inférieure et une partie supérieure pour effectuer la mise en contact du produit à traiter, les agrafes
i. présentant une conductibilité électrique,
ii. ayant une partie supérieure en métal,
iii. étant mobiles l'une par rapport à l'autre et
iv. présentant respectivement au moins un point de contact pour le produit à traiter, ainsi que
c. au moins une source de courant pour produire un flux de courant entre les contre-électrodes et les agrafes,
**caractérisé en ce qu'**entre les contre-électrodes (2,3) et les agrafes (4) sont disposés des écrans supérieurs et inférieurs (15,16) pour le champ électrique, qui s'approchent suffisamment du niveau de transport pour que le produit à traiter guidé au niveau de transport et les parties d'agrafes (13,14) puissent juste ne pas encore être touchés par les écrans.

12. Procédé selon la revendication 11, **caractérisé en ce que** l'épaisseur des couches métalliques est égalisée lors de la métallisation électrolytique du produit à traiter et **en ce que** les contre-électrodes sont commutées en tant qu'anode et le produit à traiter en tant que cathode.
